Europäisches Patentamt

European Patent Office

Office européen des brevets

(19)

(11) Veröffentlichungsnummer : **0 042 853**
**B1**

(12) EUROPÄISCHE PATENTSCHRIFT

(45) Veröffentlichungstag der Patentschrift :
04.07.84

(21) Anmeldenummer : 81900197.5

(22) Anmeldetag : 29.12.80

(86) Internationale Anmeldenummer :
PCT/NL 80/00041

(87) Internationale Veröffentlichungsnummer :
WO/8101916 (09.07.81 Gazette 81/16)

(51) Int. Cl.³ : **H 01 Q 23/00**, H 04 B 1/18,
H 03 J 3/18

(54) ABSTIMMBARE EMPFÄNGEREINGANGSSCHALTUNG.

(30) Priorität : 31.12.79 DE 2952793

(43) Veröffentlichungstag der Anmeldung :
06.01.82 Patentblatt 82/01

(45) Bekanntmachung des Hinweises auf die Patenterteilung : 04.07.84 Patentblatt 84/27

(84) Benannte Vertragsstaaten :
DE FR GB

(56) Entgegenhaltungen :
DE-A- 2 554 829
GB-A- 1 151 048
US-A- 3 693 096
Rundfunk Technische Mitteilungen, Jahrgang 21,
Heft 6, veröffentlicht im Dezember 1977, DE, H.
LINDENMEIER: "Aktive Auto-Antennen für Standard
Empfänger und elektronisch abstimmbare Empfänger" Seiten 253 bis 260

(73) Patentinhaber : **N.V. Philips' Gloeilampenfabrieken**
**Groenewoudseweg 1**
**NL-5621 BA Eindhoven (NL)**

(72) Erfinder : **LINDENMEIER, Heinz**
**Fürstenriederstrasse 7**
**D-8033 Planegg (DE)**

(74) Vertreter : **De Jongh, Cornelis Dominicus**
**INTERNATIONAAL OCTROOIBUREAU B.V. Prof.**
**Holstlaan 6**
**NL-5656 AA Eindhoven (NL)**

### Beschreibung

Die Erfindung betrifft abstimmbare Empfängereingangsschaltung mit einem verstärkenden Dreipol mit Feldeffekttransistor und mit einem nachgeschalteten verlustarmen Resonanznetzwerk für den wahlweisen Betrieb mit einer passiven oder einer aktiven Empfangsantenne, die jeweils über eine Antennenleitung mit dem Eingang der Empfängereingangsschaltung verbunden ist, wobei der Quellanschluss des aktiven Dreipols mit dem einen Eingangsanschluss des Resonanznetzwerks und der andere Eingangsanschluss des Resonanznetzwerks mit dem zweiten Eingangsanschluss der Empfängereingangsschaltung hochfrequent verbunden ist.

Es ist erforderlich, eine Empfängereingangsschaltung so zu gestalten, dass sie einerseits hinreichende Empfindlichkeit für den Empfang kleiner Signale besitzt, andererseits bei Auftreten grosser Signale Störungen durch nichtlineare Effekte in nichtlinearen Empfängerelementen soweit wie möglich verhindert. Ferner müssen bei Überlagerungsempfängern Massnahmen getroffen sein, dass Signale der Spiegelfrequenzen ausreichend unterdrückt werden, bevor sie im Mischer in den Zwischenfrequenzbereich umgesetzt werden.

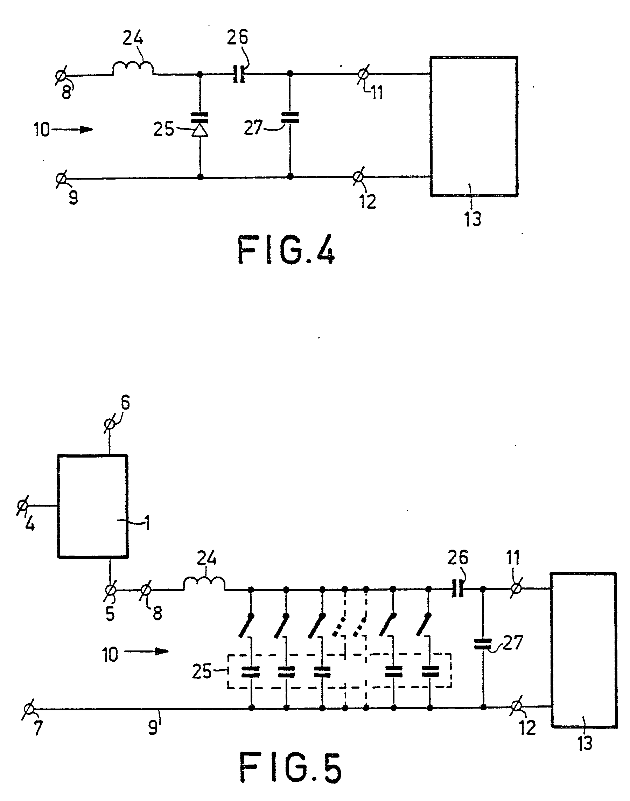

Es ist bekannt, zur Erfüllung dieser Erfordernisse, die Empfängereingangsschaltung mit einem abstimmbaren Empfängereingangskreis zu versehen. Standardautoempfänger sind für die Verwendung mit ca. 1 m langen passiven Stabantennen ausgelegt, die im Lang-, Mittel- und Kurzwellenbereich wesentlich kürzer sind als eine Viertelwellenlänge und somit kapazitiv. Die Antennenkapazität und die Kapazität der Antennenzuleitung werden in den abstimmbaren Empfängereingangskreis mit einbezogen. Aus gründen der Empfindlichkeit werden solche Emp-fängereingangschaltungen bekanntlich hoch-ohmig induktiv und deshalb, nach derzeitigem Stand der Technik, mechanisch abgestimmt ; siehe z. B. « Rundfunk-Technische Mitteilungen » 1977, 6, 253-260, insbesondere Figur 4. Solche Empfängereingangsschaltungen sind auch für den Betrieb mit aktiven Antennen geeignet, wie sie u. a. aus DE-A-1 919 749 und 2 554 829 bekannt sind. Grundlegender Nachteil dieser Art von Eingangsschaltung ist ihre mechanische, hochohmig induktive Abstimmung. Die mechanische Abstimmung ist in mehrlei Hinsicht unerwünscht. Hier sind vor allem die mit grosser Trägheit behaftete Frequenzeinstellung, sowie der Platzbedarf für die mechanische Anwendung zu nennen. Eine weitgehend trägheitslose Abstimmung für den praktischen Einsatz in einer Serienproduktion kann derzeit nur mit kapazitiven Abstimmelementen realisiert werden. Die na-heliegende Anwendung von kapazitiven Ab-stimmelementen an Stelle der Variometerab-stimmung in der abstimmbaren Eingangs-schaltung des Standardempfängers kann mit Rücksicht auf das Signal-Rausch-Verhältnis beim Betrieb mit passiven Antennen nicht in Betracht gezogen werden. Bei einer Empfangsanordnung mit aktiver Antenne, wie sie aus der Figur 8 der genannten Literaturstelle « Rundfunk-Technische Mitteilungen » und aus DE-A-25 54 828 be-kannt ist, kann die Einstellung der Resonanzfrequenz durch eine im Netzwerk am Empfängereingang befindliche Spule mit einstellbarer Induktivität und/oder durch einen Kondensator mit ein-stellbarer Kapazität geschaffen werden. Nachtei-lig ist jedoch, dass insbesondere bei kapazitiver Abstimmung, bzw. bei nicht hinreichend hoch-ohmig induktiver Abstimmung, eines ent-sprechend ausgeführten Netzwerks am Emp-fängereingang keine geeignete Schnittstelle ent-steht, derart, dass der so gestaltete Empfänger wahlweise auch mit der üblichen passiven Stabantenne mit Antennenzuleitung betrieben werden könnte. Der Empfängereingangsschaltung fehlt somit das Merkmal der wahlweisen Verwendbarkeit (Kompatibilität) im Hinblick auf die zu verwendende Antennenart. Die Kompatibilität ist in der Praxis von Bedeutung, da die Empfängerherstellung von der Frage, ob eine passive Stabantenne oder eine aktive Antenne mit diesem Empfänger betrieben werden soll, unberührt ist. Eine wahlweise Verwendbarkeit der Empfängereingangsschaltung für beide Antennenarten ist im Sinne der vorliegenden Betrachtungen nur dann gegeben, wenn sich für die Gesamtanordnung, bestehend aus Antenne und Empfängereingangsschaltung, in beiden Fällen im Hinblick auf die Empfindlichkeit, die Selektion und die Intermodulationsfestigkeit die zu fordernden Empfangseigenschaften ergeben.

Die Aufgabe der Erfindung ist es, bei einer abstimmbaren Empfängereingangsschaltung die in Standard-Autosupern übliche hochohmig induktive Abstimmung zu vermeiden und sowohl mit einer aktiven Antenne mit nachgeschalteter Antennenleitung als auch mit einer passiven An-tenne mit nachgeschalteter Antennenleitung opti-male Empfangsergebnisse zu erzielen.

Diese Aufgabe wird erfindungsgemäss dadurch gelöst, dass der Steueranschluss des aktiven Dreipols ohne vorgeschaltetes Resonanznetzwerk direkt mit dem ersten Eingangsanschluss der Empfängereingangsschaltung hochfrequent verbunden ist und der Feldeffekt-Transistor des aktiven Dreipols als Sourcefolter geschaltet ist, dessen Source direkt mit der Steuerelektrode eines Bipolartransistors verbunden ist zur An-steuerung des Bipolartransistors in Emitterfolger-schaltung, und dass das Resonanznetzwerk, bezogen auf seine Eingangsklemmen, aus der Serienschaltung einer Induktivität und einer Kapazität besteht und das Ausgangssignal für die wei-terführende, eingangsseitig hochohmige Emp-fängerschaltung an den Ausgangsklemmen pa-rallel zu einem der beiden Blindelemente abgegriffen wird, das Ganze derart, dass die Ein-gangsimpedanz des Resonanznetzwerks als ge-

genkoppelnde Impedanz zur Linearisierung des aktiven Dreipols wirkt und bei Beschaltung der Ausgangsklemmen des Resonanznetzwerks mit der weiterführenden Empfängerschaltung diese Impedanz durch Einstellung eines oder beider Blindelemente des Resonanznetzwerks bei der Betriebsfrequenz des Empfängers nahezu ein Minimum ihres Scheinwiderstands besitzt und der Scheinwiderstand mit wachsendem Abstand der Frequenz von der Betriebsfrequenz wächst.

An dieser Stelle wird bemerkt, dass aus der amerikanischen Patentschrift 3,693,096 eine abstimmbare Empfängereingangsschaltung bekannt ist mit einem verstärkenden Dreipol mit Feldeffekttransistor und mit einem Resonanznetzwerk, bei dem der aktive Dreipol einen Steueranschluss besitzt, der ohne vorgeschaltetes Resonanznetzwerk direkt mit dem ersten Eingangsanschluss der Empfängereingangsschaltung hochfrequent verbunden ist und der Quellanschluss des aktiven Dreipols mit dem einen Eingangsanschluss des Resonanznetzwerks und der andere Eingangsanschluss des Resonanznetzwerks mit dem zweiten Eingangsanschluss der Empfängereingangsschaltung hochfrequent verbunden ist, wobei das Resonanznetzwerk, bezogen auf seine Eingangsklemmen aus der Serienschaltung einer Induktivität und einer Kapazität besteht und das Ausgangssignal für die weiterführende, eingangsseitig hochohmige Empfangsschaltung an den Ausgangsklemmen und parallel zu einem der beiden Blindelementen abgegriffen wird, das Ganze derart dass die Eingangsimpedanz des Resonanznetzwerks als gegenkoppelnde Impedanz des aktiven Dreipols wirkt und das Resonanznetzwerk so gestaltet ist, dass bei Beschaltung der Ausgangsklemmen des Resonanznetzwerks mit der weiterführenden Empfängerschaltung diese Impedanz durch Einstellung eines oder mehrerer Blindelemente des Resonanznetzwerks bei der Betriebsfrequenz des Empfängers nahezu ein Minimum ihres Scheinwiderstands besitzt und der Scheinwiderstand mit wachsendem Abstand der Frequenz von der Betriebsfrequenz wächst.

Sie betrifft aber eine Empfängereingangsschaltung für eine passive Empfangsantenne. Schließt man eine derartige Empfängereingangsschaltung an eine aktive Empfangsantenne an, so ergibt sich keine optimale Unterdrückung von unerwünschten Störprodukten infolge der in der aktiven Antenne auftretenden Intermodulation und Kreuzmodulation.

Die Wirkungsweise der Erfindung sowie der erzielbaren Vorteile werden anhand von Zeichnungen erläutert. Es zeigen

Figur 1 Empfangsanordnung mit aktiver oder passiver Antenne und abstimmbarer Empfängereingangsschaltung nach der Erfindung.

Figur 2 Beispiel einer aktiven Antenne.

Figur 3 Empfängereingangsschaltung mit diodenabgestimmtem Resonanznetzwerk, bei dem der aktive Dreipol eine Ausgangstransistorschaltung mit hochfrequent parallelgeschalteten komplementären Bipolartransistoren besitzt.

Figur 4 Resonanznetzwerk mit kapazitiver Teilankopplung der weiterführenden Empfängerschaltung 13.

Figur 5 Empfängereingangsschaltung mit stufenweise veränderbarer Kapazität zur Einstellung der Resonanzfrequenz.

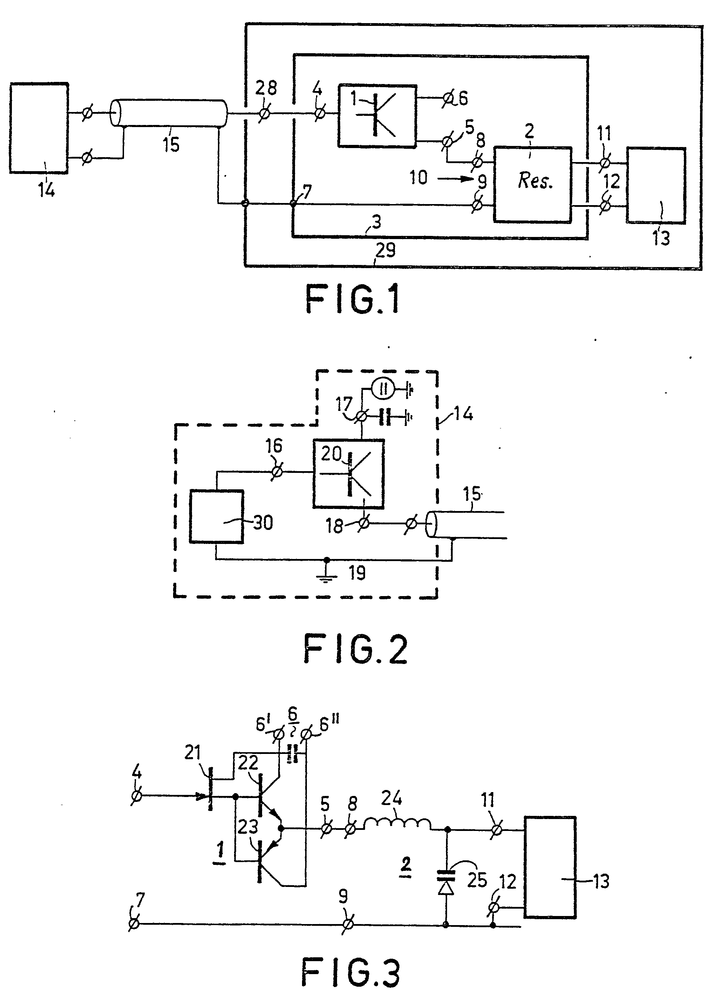

Fig. 1 zeigt eine aktive oder passive Antenne 14, die über eine Antennenzuleitung 15 eine Empfängereingangsschaltung 3 nach der Erfindung zwischen den Klemmen 4 und 7 ansteuert. Der Steuerstrecke, das sind die Anschlüsse 4 und 5, des aktiven Dreipols, ist die Eingangsimpedanz 10 des Resonanznetzwerks in Serie geschaltet, so dass der aktive Dreipol 1 bei der Quellelektrode 5 mit der Eingangsimpedanz 10 des Resonanznetzwerks 2 frequenzabhängig gegengekoppelt wird. Das Resonanznetzwerk ist erfindungsgemäss so auszubilden, dass diese gegenkoppelnde Impedanz bei der Betriebsfrequenz des Empfängers nahezu einen Kleinstwert des Scheinwiderstands besitzt und ihr Scheinwiderstand mit wachsendem Abstand der Frequenz von der Betriebsfrequenz wächst, diese Impedanz demnach den Charakter eines Serienresonanzkreises besitzt, dessen Resonanzfrequenz in der Nähe der Betriebsfrequenz liegt.

Dann ist die Gegenkopplung bei der Betriebsfrequenz am kleinsten und daher die Verstärkung im Hinblick auf das an den Ausgangsklemmen 11 und 12 im Betrieb auftretende Ausgangssignal bei der Betriebsfrequenz am grössten. Die Verstärkung wird umso kleiner, je mehr sich die Frequenz von der Resonanzfrequenz entfernt. Der Scheinwiderstand eines Serienresonanzkreises hat bei der Resonanzfrequenz einen Kleinstwert und ist dort nahezu reell. Bei Frequenzen unterhalb der Resonanzfrequenz ist die Impedanz des Resonanzkreises kapazitiv, oberhalb der Resonanzfrequenz induktiv. Mit wachsendem Abstand der Frequenz von der Resonanzfrequenz nimmt die Grösse des Scheinwiderstands zu. Mit wachsendem Scheinwiderstand wird die wirksame Gegenkopplung des aktiven Dreipols grösser, d. h. die Bildung von Störprodukten in Folge von Intermodulation und Kreuzmodulation im aktiven Dreipol wird kleiner. Der aktive Dreipol wird somit im Hinblick auf unerwünschte Signale bei Frequenzen ausserhalb der Resonanzfrequenz nach Massgabe des gegenkoppelnden Scheinwiderstands linearisiert. Zusätzlich bewirkt das verlustarme Resonanznetzwerk vor dem an die Klemmen 11 und 12 angeschalteten weiterführenden Empfängerteil 13 eine Frequenzselektion und behindert auch dort durch seine Frequenzselektion das Auftreten nichtlinearer Effekte in diesem Empfängerteil, wie z. B. im Mischer.

Die Kompatibilität der Empfängereingangsschaltung wird im folgenden anhand eines Beispiels einer aktiven Antenne in Fig. 2 im Vergleich mit einer passiven Stabantenne erläutert. Die aktive Antenne besteht nach Fig. 2 aus einem passiven Antennenteil 30, einem aktiven Dreipol und einer hochfrequent gegenkoppelnden Impedanz, die in diesem Beispiel durch die Eingangsimpedanz des Kabels gebildet wird. Der passive Antennenteil 30 besitzt zwei Anschlüsse 16 und 19, wobei 19 als der Massepunkt der aktiven Antenne bezeichnet wird und im Kraftfahrzeug mit der Karosserie verbunden ist. Der aktive Dreipol enthält mindestens einen Transistor 20 und hat drei Anschlüsse 16, 17 und 18. Im vorliegenden Fall mit Gegenkopplung, bei dem aus der gegenkoppelnden Impedanz das Ausgangssignal des Dreipols entnommen wird, ist 18 der hochfrequente Ausgangssignalanschluss des Dreipols. Wenn der Dreipol einen bipolaren Ausgangstransistor 20 besitzt, ist 18 beispielsweise der Emitteranschluss des Ausgangstransistors. Der Dreipol hat einen Steueranschluss 16 und die Steuerspannung des Dreipols liegt zwischen den Anschlüssen 16 und 18. Der Steueranschluss des Dreipols ist an den Anschluss 16 des passiven Antennenteils angeschlossen. Die gegenkoppelnde Impedanz liegt zwischen dem Ausgangssignalanschluss 18 des Dreipols und dem Massepunkt 19. Die hochfrequent gegenkoppelnde Impedanz ist die Eingangsimpedanz des Antennenausgangskabels 15, dessen einer Leiter mit dem Massepunkt 19 verbunden ist und das das Ausgangssignal der am Kabelausgang 28, 7 angeschlossenen Empfängereingangsschaltung 3 bei den Klemmen 4 und 7 zuführt. Die Antennenzuleitung 15 ist an ihrem Ende mit der vergleichsweise hochohmigen Eingangsimpedanz der Empfängereingangsschaltung nach der Erfindung abgeschlossen, deren Hochohmigkeit mit wachsendem Frequenzabstand von der Betriebsfrequenz des Empfängers anwächst. Da die Länge der Antennenzuleitung 15 im LMK-Bereich kurz ist im Vergleich zur Wellenlänge, wirkt deshalb die Eingangsimpedanz der Leitung zwischen den Klemmen 18 und 19 als hochohmige Gegenkopplungsimpedanz des aktiven Dreipols in der aktiven Antenne. Das Signal-Rausch-Verhältnis der Anordnung wird dabei wesentlich von der Ausgestaltung der aktiven Antenne bestimmt und kann auf an sich bekannte Weise optimiert werden. Wird nun die aktive Antenne 14 durch die bekannte passive Stabantenne 14 ersetzt, so stellt die Antenne mit Antennenzuleitung eine kapazitiv hochohmige Signalquelle dar. Bei Wahl eines aktiven Dreipols mit entsprechend kleinem äquivalenten Rauschwiderstand in Kombination mit einem hinreichend kleinen Eingangswiderstand 10 des Resonanznetzwerks bei der Resonanzfrequenz wird auch mit der passiven Antenne das erforderliche Signal-Rausch-Verhältnis erzielt. Selektion und Linearität werden durch ein hinreichend schmalbandiges Resonanznetzwerk erreicht.

Die mit der Erfindung erzielten Vorteile bestehen insbesondere in der Möglichkeit der kapazitiven Abstimmung des Resonanznetzwerks ohne Verlust an Signal-Rausch-Verhältnis, in Kombination mit optimaler Empfindlichkeit und Linearität beim wahlweisen Betrieb mit einer üblichen passiven Antenne und einer aktiven Antenne.

Fig. 3 zeigt eine vorteilhafte Weiterbildung der Erfindung. Der aktive Dreipol besteht aus einer Kombination aus drei Transistoren mit einem Feldeffekt-Transistor 21 und einer Ausgangstransistorschaltung, die aus der hochfrequenten Parallelschaltung aus zwei Bipolartransistoren 22 und 23 besteht. Der so entstandene aktive Dreipol besitzt den Charakter eines Feldeffekt-Transistors mit vergrösserter Vorwärtssteilheit und dem Quellanschluss 5 und dem Steueranschluss 4. Den Anschlüssen 6' und 6'', die hochfrequent zu 6 zusammengefasst sind, kommt lediglich die Aufgabe der Ruhestromzuführung zu. Mit einem Dreipol dieser Art können, in Kombination mit der an den Ausgangsklemmen 11 und 12 angeschlossenen hochohmigen hochfrequenten Last 13 und den unvermeidbaren Verlusten des an sich verlustarmen Resonanznetzwerks, hohe Gegenkopplungsgrade und damit ein hohes Mass an selektiver Linearisierung bei gleichzeitig optimalem Signal-Rausch-Verhältnis erzielt werden. Die Induktivität 24 und die Kapazität 25 bilden im Hinblick auf die Klemmen 8 und 9 einen Serienresonanzkreis, dessen Kondensator zwischen den Klemmen 11 und 12 mit der hochohmigen Schaltung 13 belastet ist. Diese Schaltung kann eine weitere Verstärker- oder eine Mischerschaltung darstellen.

Vielfach ist für die Ankopplung der Schaltung 13 im Hinblick auf den im Betrieb auftretenden Pegelbereich eine Teilankopplung optimal, die als Weiterbildung der Erfindung in Fig. 4 als kapazitive Teilankopplung mit den Teilkapazitäten 26 und 27 ausgeführt ist. Die variable Kapazität ist in Fig. 3 und Fig. 4 als Kapazitätsdiode ausgeführt, die den Nachteil eines mangelhaften Grosssignalverhaltens aufweist. Gemäss einer vorteilhaften Weiterbildung der Erfindung kann deshalb an Stelle einer kontinuierlich veränderbaren Kapazität 25 eine Reihe von Festkondensatoren eingesetzt werden, die, wie in Fig. 5, über Schaltdioden oder Schaltkontakte mit kurzer Schaltzeit parallel geschaltet oder/und in Serie geschaltet werden können. Bei vorgegebener Zuordnung von Resonanzfrequenz und Schalterstellungen und bei Kenntnis der Betriebsfrequenz des Empfängers kann das Resonanznetzwerk in extrem kurzer Zeit auf die gewünschte Frequenz eingestellt werden. Liegt die Frequenzinformation in digitaler Form vor, so können die Schalter, bzw. Schaltdioden, sehr vorteilhaft über ein PROM in den gewünschten Schaltzustand versetzt werden.

**Ansprüche**

1. Abstimmbare Empfängereingangsschaltung (3), mit einem verstärkenden Dreipol (1) mit Feldeffekttransistor (21) und mit einem nachgeschalteten verlustarmen Resonanznetzwerk (2), für den wahlweisen Betrieb mit einer passiven oder einer aktiven Empfangsantenne (14), die jeweils über eine Antennenleitung (15) mit dem Eingang der Empfängereingangsschaltung verbunden ist, wobei der Quellanschluss (5) des aktiven Dreipols mit dem einen Eingangsanschluss (8) des Resonanznetzwerks (2) und der andere Eingangsanschluss (9) des Resonanznetzwerks mit dem zweiten Eingangsanschluss (7) der Empfängereingangsschaltung (3) hochfrequent verbunden ist, dadurch gekennzeichnet, dass der Steueranschluss (4) des aktiven Dreipols (1) ohne vorgeschaltetes Resonanznetzwerk direkt mit dem ersten Eingangsanschluss (28) der Empfängereingangsschaltung (3) hochfrequent verbunden ist und der Feldeffekt-Transistor (21) des aktiven Dreipols als Sourcefolger geschaltet ist, dessen Source direkt mit der Steuerelektrode eines Bipolartransistors (22) verbunden ist zur Ansteuerung des Bipolartransistors in Emitterfolgerschaltung, und dass das Resonanznetzwerk, bezogen auf seine Eingangsklemmen (8, 9), aus der Serienschaltung einer Induktivität (24) und einer Kapazität (25) besteht und das Ausgangssignal für die weiterführende, eingangsseitig hochohmige Empfängerschaltung (13) an den Ausgangsklemmen (11, 12) parallel zu einem der beiden Blindelemente abgegriffen wird, das Ganze derart, dass die Eingangsimpedanz (10) des Resonanznetzwerks als gegenkoppelnde Impedanz zur Linearisierung des aktiven Dreipols wirkt und bei Beschaltung der Ausgangsklemmen (11, 12) des Resonanznetzwerks mit der weiterführenden Empfängerschaltung (13) diese Impedanz durch Einstellung eines oder beider Blindelemente des Resonanznetzwerks bei der Betriebsfrequenz des Empfängers (29) nahezu ein Minimum ihres Scheinwiderstands besitzt und der Scheinwiderstand mit wachsendem Abstand der Frequenz von der Betriebsfrequenz wächst.

2. Empfängereingangsschaltung nach Anspruch 1, dadurch gekennzeichnet, dass dem Bipolartransistor (22) ein weiterer, zu ihm komplementärer Bipolartransistor (23) parallelgeschaltet ist.

3. Empfängereingangschaltung nach Anspruch 1, dadurch gekennzeichnet, dass die weiterführende Empfängerschaltung (13) über eine kapazitive Teilankopplung (26, 27) der einstellbaren Kapazität (25) parallelgeschaltet ist.

## Claims

1. A tunable receiver input circuit (3) having an amplifying three-terminal network (1) with field-effect transistor (21) and subsequent thereto a lowloss resonant network and an amplifying three-terminal network (2), for optional operation with a passive or an active receiving aerial (14) which is connected to each input of the receiver input circuit via an aerial line (15), the source terminal (5) of the active three-terminal network being connected to one input terminal (8) of the resonant network (2) and the other input terminal (9) of the resonant network being connected for radio frequency to the second input terminal (7) of the receiver input circuit (3), characterized in that the control terminal (4) of the active three-terminal network (1) without preceding resonant network is directly connected for radio frequency to the first input terminal (28) of the receiver input circuit (3) and the field effect transistor (21) of the active three-terminal network is connected as a source follower, whose source is directly connected to the control electrode of a bipolar transistor (22) to control the bipolar transistor in the emitter follower circuit, and that the resonant network, in relation to its input terminals (8, 9) is formed by the series arrangement of an inductance (24) and a capacitance (25) and that the output signal for the through-connecting receiving circuit (13), which is high-impedance at its input side is taken from the output terminals (11, 12) in parallel with one of the two reactive components, all this such that the input impedance (10) of the resonant network acts as a negative feedback impedance to linearize the active three-terminal network and upon connecting the output terminals (11, 12) of the resonant network to the through-connecting receiving circuit (13) this impedance has substantially a minimum value at the operating frequency of the receiver (29) as a result of the adjustment of one or both reactive elements of the resonant network and that the impedance increases with increasing distance of the frequency from the operating frequency.

2. A receiver input circuit as claimed in Claim 1, characterized in that there is arranged in parallel with the bipolar transistor (22) a further bipolar transistor (23) which is complementary to the fist-mentioned bipolar transistor.

3. A receiver input circuit as claimed in Claim 1, characterized in that the through-connecting receiver circuit (13) is connected in parallel with the adjustable capacitance (25) via a capacitive partial coupling (26, 27).

## Revendications

1. Dispositif d'entrée récepteur accordable (3), comportant un tripôle amplificateur (1) muni d'un transistor à effet de champ (21) derrière lequel est inséré un réseau de résonance à faible perte (2), pour le fonctionnement facultatif avec une antenne réceptrice passive ou active (14), qui est connectée chaque fois par l'intermédiaire d'un conducteur d'antenne (15) à l'entrée du dispositif d'entrée récepteur, la borne de source (5) du tripôle actif étant connectée, à haute fréquence, à une borne d'entrée (8) du réseau de résonance (2) et l'autre borne d'entrée (9) du réseau de résonance étant connectée à haute fréquence à la deuxième borne d'entrée (7) du dispositif d'entrée récepteur (3), caractérisé en ce que la borne de commande (4) du tripôle actif (1) étant connectée à haute fréquence, sans réseau de résonance intercalé, de façon directe à la première borne d'entrée (28) du dispositif d'entrée récepteur (3) et le transistor à effet de champ (21) du tripôle actif est monté comme source suiveuse, dont la source est connectée de façon directe à l'électrode de commande d'un transistor bipolaire (22) pour la commande du transistor bipolaire en montage émetteur suiveur, et que le réseau de résonance, pour en ce qui concerne ses bornes d'entrée (8, 9), est constitué par le montage en série d'une inductivité (24) et d'une capacité (25) et que le signal de sortie pour le circuit récepteur, à valeur ohmique élevée, continue (13) prévu du côté entrée est prélevé sur les bornes de sortie (11, 12) parallèlement à un élément réactif ou les deux, le tout de façon que l'impédance d'entrée (10) du réseau de résonance agisse comme impédance de contre-réaction pour linéariser le tripôle actif et dans le cas de connexion aux bornes de sortie (11, 12) du réseau de résonance d'un circuit récepteur continu (13), cette impédance présente une valeur minimale de sa résistance apparente par réglage d'un élément réactif ou les deux du réseau de résonance à la fréquence de fonctionnement du récepteur (29), résistance apparente qui augmente avec la distance comprise entre la fréquence et la fréquence de fonctionnement.

2. Dispositif d'entrée récepteur selon la revendication 1, caractérisé en ce qu'au transistor bipolaire (22) est monté en parallèle un autre transistor bipolaire complémentaire (23).

3. Dispositif d'entrée récepteur selon la revendication 1, caractérisé en ce que le circuit récepteur connu (13) est monté en parallèle par l'intermédiaire d'un couplage partie capacitif (26, 27) à une capacité réglable (25).

0 042 853

FIG.1

FIG.2

FIG.3

1

FIG.4

FIG.5

2